Europäisches Patentamt

European Patent Office

Office européen des brevets

(19)

(11) Numéro de publication : **0 474 565 A1**

# (12) DEMANDE DE BREVET EUROPEEN

(21) Numéro de dépôt : **91420263.5**

(22) Date de dépôt : **19.07.91**

(51) Int. Cl.⁵ : **H02H 3/093**

(30) Priorité : **01.08.90 FR 9009939**

(43) Date de publication de la demande :
**11.03.92 Bulletin 92/11**

(84) Etats contractants désignés :
**BE CH DE ES GB IT LI SE**

(71) Demandeur : **MERLIN GERIN
2, chemin des Sources
F-38240 Meylan (FR)**

(72) Inventeur : **Fraisse, Didier
MERLIN GERIN, Sce. Brevets
F-38050 Grenoble Cedex (FR)**
Inventeur : **Levain, Marc
MERLIN GERIN, Sce. Brevets
F-38050 Grenoble Cedex (FR)**

(74) Mandataire : **Kern, Paul et al
Merlin Gerin Sce. Brevets
F-38050 Grenoble Cédex (FR)**

(54) **Déclencheur électronique à fonction court-retard.**

(57)    Le circuit de temporisation court-retard comporte un compteur (4) remis à zéro lorsque le signal (I) représentatif du courant est supérieur ou égal à un seuil (Is), et contrôle (A2) le décomptage d'un compteur/décompteur (5), lorsque le contenu du compteur atteint une valeur prédéterminée. Un circuit d'horloge (6) commande la fréquence de comptage et de décomptage du compteur (4) et du compteur/décompteur (5).

EP 0 474 565 A1

FIG.1

L'invention concerne un déclencheur électronique comportant des moyens de réalisation d'une fonction court-retard, destinés à produire un signal de déclenchement lorsqu'un signal d'entrée, représentatif du courant parcourant au moins un conducteur à protéger, est supérieur à une valeur de seuil prédéterminée pendant une durée de temporisation prédéterminée, lesdits moyens comportant des moyens de comparaison du signal d'entrée et de la valeur de seuil produisant en sortie un signal lorsque le signal d'entrée est supérieur à la valeur de seuil, et des moyens de temporisation connectés à la sortie des moyens de comparaison.

Dans les déclencheurs électroniques classiques les temporisations des fonctions long et court-retard sont réalisées au moyen de circuit RC. Une tension représentative du courant traversant le conducteur à protéger est appliquée au circuit de temporisation, lorsque l'amplitude du courant dépasse un seuil court ou long retard prédéterminé. Le circuit de temporisation fournit un signal de déclenchement lorsque son signal de sortie atteint une valeur prédéterminée.

Le brevet US-A-3.792.313 décrit un circuit de ce type dans lequel la remise à zéro du circuit de temporisation, lorsque l'amplitude du courant repasse au-dessous dudit seuil prédéterminé, est retardée. Un tel retard peut être de l'ordre de 20ms lorsque la fréquence du courant mesuré est de 60Hz, permettant ainsi de s'affranchir de la forme du signal de courant entre deux valeurs crêtes, et, en particulier d'utiliser un signal de courant redressé non filtré.

Dans ce type de circuit l'incertitude sur la valeur de la temporisation est typiquement de l'ordre de 20 à 30%, et la fiabilité du circuit peut être réduite par l'utilisation de condensateurs de temporisation de capacité élevée.

L'invention a pour but un déclencheur statique dans lequel la fonction court-retard est réalisée avec une temporisation beaucoup plus précise, tout en augmentant la fiabilité du circuit.

Ce but est atteint par le fait que les moyens de temporisation comportent un compteur et un compteur/décompteur comportant chacun une entrée horloge recevant d'un circuit d'horloge, des signaux d'horloge de fréquences prédéterminées, une entrée de remise à zéro du compteur étant connectée à la sortie des moyens de comparaison, la sortie du compteur étant reliée à une entrée de comptage/décomptage du compteur/décompteur de manière à en commander le décomptage lorsque le contenu du compteur atteint une première valeur prédéterminée, le compteur/décompteur fournissant un signal de déclenchement lorsque son contenu atteint une seconde valeur prédéterminée.

L'utilisation de compteurs actionnés à des fréquences prédéterminées, fixes, permet d'augmenter très largement la précision de la temporisation, qui peut alors être de l'ordre de 5%. La suppression des condensateurs de temporisation augmente largement la fiabilité du circuit. Un tel circuit est de plus facilement intégrable, notamment dans un circuit du type intégré à la demande(ASIC),ce qui permet également d'en réduire le coût et le volume. L'utilisation d'un compteur/décompteur permet d'introduire une mémoire thermique dans le circuit court-retard.

Selon un développement de l'invention, le temps de retard, nécessaire pour que le contenu du compteur atteigne la première valeur prédéterminée en l'absence de remise à zéro du compteur, est supérieur ou égal à un quart de période du courant, par exemple supérieur ou égal à 5ms pour un courant de 50Hz.

Lorsque ledit temps de retard est supérieur ou égal à une demi-période du courant, par exemple supérieur ou égal à 10ms pour un courant de 50Hz, la temporisation est insensible à la forme du signal, notamment lorque le déclencheur est associé à un disjoncteur monophasé.

Selon un dévelopement de l'invention, ledit temps de retard est inférieur à la différence entre la durée de temporisation prédéterminée et un temps de non déclenchement prédéterminé.

Il est par ailleurs très facile de modifier avec précision la durée de la temporisation, par simple modification de la fréquence des signaux d'horloge.

D'autres avantages et caractéristiques ressortiront plus clairement de la description qui va suivre d'un mode particulier de réalisation de l'invention, donné à titre d'exemple non limitatif et représenté aux dessins annexés sur lesquels:

La figure 1 représente un mode de réalisation particulier d'un déclencheur selon l'invention.

Les figures 2 et 3 illustrent les formes d'onde des signaux en divers points du déclencheur selon la figure 1, respectivement pour des temps de retard R de 10 et 5ms.

Les figures 4 et 5 représentent les courbes de déclenchement court-retard d'un déclencheur selon l'invention, respectivement pour des temps de retard R≧10ms et R=5ms.

La figure 6 représente la temporisation T en fonction du temps de retard R lorsque le courant I est égal au seuil Is.

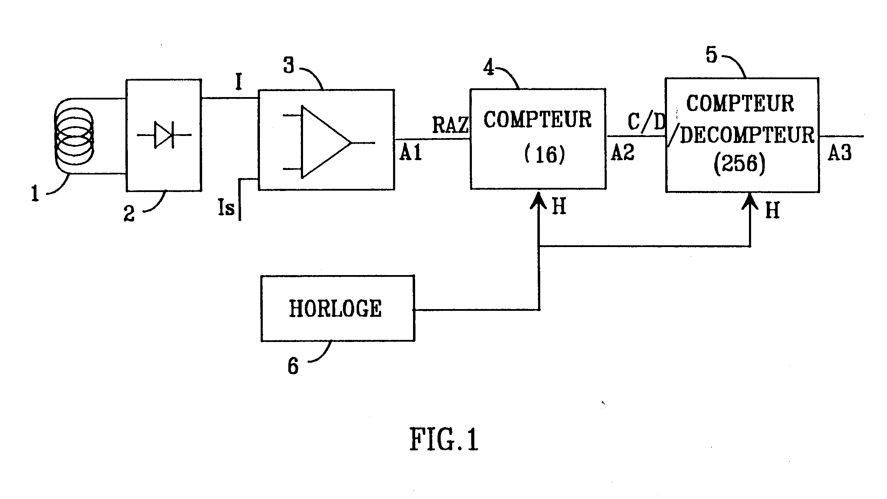

Le déclencheur selon la figure 1 comporte un capteur de courant 1 connecté à un circuit redresseur 2, de préférence constitué par un redresseur à double alternance. Le signal I de sortie du circuit redresseur 2 est représentatif du courant parcourant le conducteur à protéger.

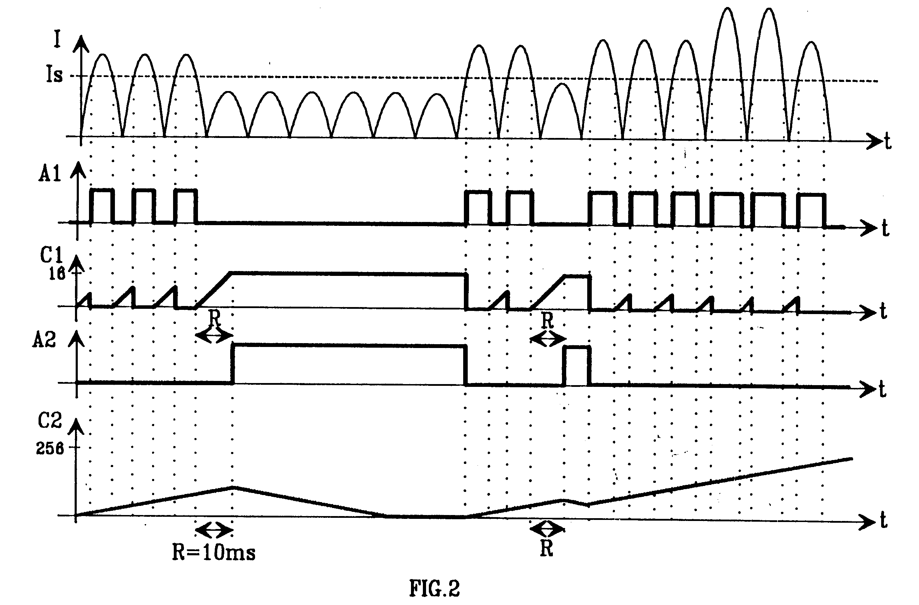

Le signal I représentatif du courant est appliqué à une entrée d'un comparateur 3 ou il est comparé à un seuil court-retard Is prédéterminé, appliqué sur une seconde entrée du comparateur. Le signal A1 de sortie du comparateur 3 est au niveau logique 1 lorsque le signal I est supérieur au seuil Is (figure 2). La sortie du comparateur 3 est connectée à l'entrée d'un circuit de temporisation dont la sortie fournit un signal de déclenchement (A3) lorsque le signal I représentatif du courant dépasse le seuil court-retard Is pendant un temps prédéterminé.

Le circuit de temporisation est constitué par un compteur 4, un compteur/décompteur 5 et un circuit d'horloge 6. Le circuit d'horloge 6 fournit des signaux d'horloge de fréquence prédéterminée aux entrées horloge du compteur 4 et du compteur/décompteur 5. Dans le mode de réalisation représentée, le même signal d'horloge H est appliqué aux deux entrées horloge.

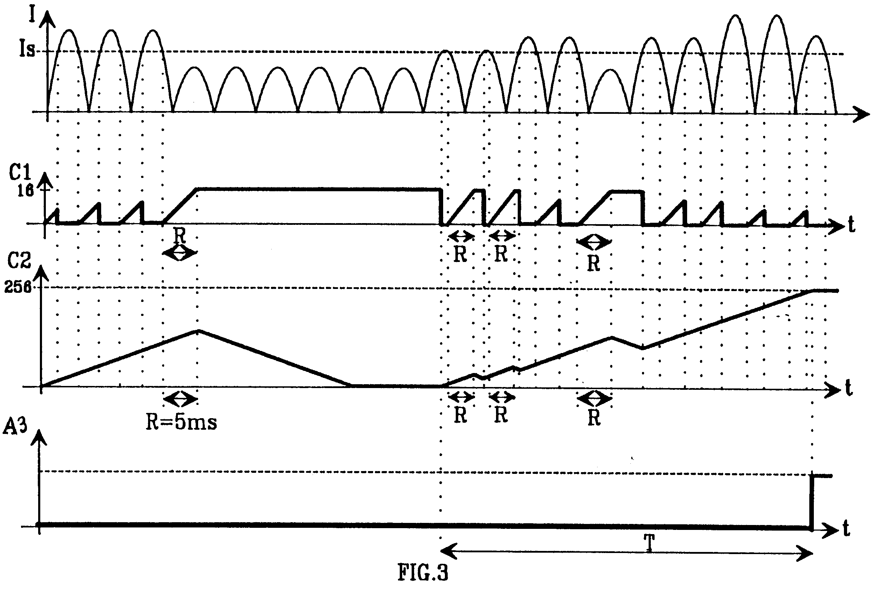

La sortie du comparateur 3 est connectée à l'entrée de remise à zéro (RAZ) du compteur 4. Celui-ci fournit en sortie un signal A2 à l'état logique 1 lorsque son contenu C1 atteint une première valeur prédéterminée, par exemple 16 dans le mode de réalisation représenté. Le contenu C1 du compteur 4 est remis à zéro lorsque le signal A1 est à l'état logique 1, c'est à dire dès que le signal I dépasse le seuil Is, et ce contenu C1 augmente jusqu'à ladite valeur prédéterminée à la fréquence du signal d'horloge H lorsque le signal I est inférieur au seuil Is (figures 2 et 3).

Le signal A2 de sortie du compteur 4 est appliqué à l'entrée C/D de comptage/décomptage du compteur/décompteur 5. Celui-ci compte, à la fréquence du signal d'horloge H, lorsque le signal A2 est à l'état bas et décompte, également à la fréquence du signal d'horloge H, lorsque le signal A2 est à l'état haut. Le compteur/décompteur fournit en sortie un signal de déclenchement A3 qui passe à l'état 1 lorsque son contenu C2 atteint une seconde valeur prédéterminée, par exemple 256 dans le mode de réalisation représenté.

De cette manière, la présence d'un signal I inférieur au seuil Is n'est transmise à l'entrée C/D du compteur/décompteur 5 qu'avec un temps de retard R correspondant au temps nécessaire au compteur 4 pour atteindre la première valeur prédéterminée, par exemple 16. Dans le cas où le signal I est représentatif d'un signal de courant monophasé, il repasse au-dessous du seuil Is à chaque alternance comme représenté sur la figure 2, même lorsque sa valeur crête est supérieure au seuil Is. Le circuit de temporisation ignore ainsi toute baisse du signal I en dessous du seuil dont la durée est inférieure au temps de retard R.

Dans le mode de réalisation selon la figure 2, le temps de retard R est égal à une demi-période du signal I, soit 10ms pour un signal dont la fréquence est de 50Hz. Le compteur/décompteur 5 ignore ainsi toutes les baisses de signal comprises entre deux valeurs crêtes successives supérieures au seuil Is. La temporisation T est ainsi rendue totalement insensible à la forme du signal lorsque le temps de retard R est supérieur ou égal à une demi-période du signal I.

Dans le mode de réalisation selon la figure 3, le temps de retard R est égal au quart d'une période du signal I, soit 5ms pour un signal dont la fréquence est de 50Hz. Lorsque le signal I a une valeur crête supérieure au seuil Is mais voisine de celle-ci, le signal I repasse en-dessous du seuil pendant une durée supérieure à R entre deux crêtes successives et le compteur/décompteur 5 compte puis décompte pendant l'intervalle de temps séparant deux valeurs crêtes successives.

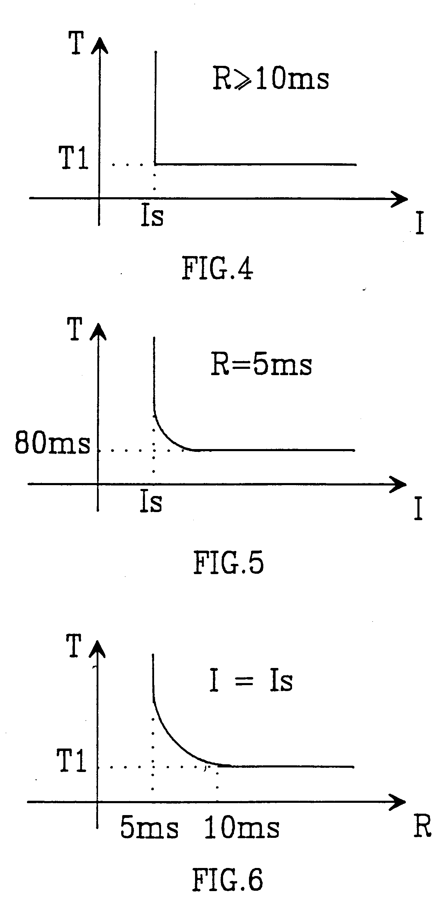

Les figures 4 et 5 illustrent les courbes de déclenchement illustrant la temporisation T en fonction du courant 1, respectivement pour un temps de retard R supérieur ou égal à une demi-période du signal I, par exemple R≧10ms pour une fréquence de 50Hz, et pour un temps de retard égal au quart de ladite période, par exemple 5ms. La seconde courbe de déclenchement (figure 5) est arrondie et comporte une asymptote pour I=Is, la durée de décomptage entre 2 valeurs crêtes étant alors égale à la durée de comptage.

Sur la figure 6 est représentée une courbe T (R) pour I=Is. La temporisation T1 est constante lorsque R≧10ms et tend vers l'infini quand R=5ms, la courbe étant arrondie entre ces deux valeurs.

En tenant compte des courbes décrites ci-dessus, il est donc possible de déterminer la valeur de R, ainsi que la fréquence de l'horloge 6 et les valeurs maximums des contenus C1 et C2 du compteur 4 et du compteur/décompteur 5, permettant d'obtenir la temporisation désirée pour un courant prédéterminé.

Sans modifier les compteurs, il est possible de modifier la temporisation court-retard en faisant varier la fréquence des signaux d'horloge, soit la fréquence du signal d'horloge H sur la figure 1, la temporisation étant alors inversement proportionnelle à la fréquence du signal d'horloge H.

A titre d'exemple, le compteur 4 étant un compteur par 16 et le compteur/décompteur 5 un compteur par 256, une fréquence d'horloge de 3,2Hz conduit à un temps de retard R de 5ms et à une temporisation minimale de 80ms, comme représenté sur les figures 3 et 5.

La mémorisation du défaut, par le compteur/décompteur 5, pendant la durée du temps de retard R, conduit à définir un temps de non-déclenchement: un ordre de déclenchement ne peut pas être émis si I est inférieur au seuil Is pendant un temps inférieur au temps de non-déclenchement. Si le temps de non déclenchement prédéterminé est souhaité, le temps de retard R doit être inférieur à la différence entre la durée prédéterminée de la temporisation court-retard et le temps de non déclenchemernt. A titre d'exemple, pour une temporisation court-retard T1=80ms, et un temps de non déclenchement souhaité de 60ms, le temps de retard R ne devra pas excéder 20ms. Il est ainsi possible de maitriser facilement le temps de non déclenchement.

L'invention est bien entendu applicable à un déclencheur associé à un disjoncteur polyphasé, par exemple triphasé,dans lequel le signal I représentatif du courant est obtenu par redressement des signaux mesurés sur les différentes phases.

Par ailleurs, le compteur 4 et le compteur/ décompteur 5 peuvent être actionnés par des signaux d'horloge de fréquences différentes, éventuellement dérivés d'un même circuit d'horloge de fréquence prédéterminée.

## Revendications

1. Déclencheur électronique comportant des moyens de réalisation d'une fonction court-retard, destinés à produire un signal (A3) de déclenchement lorsqu'un signal d'entrée (I), représentatif du courant parcourant au moins un conducteur à protéger, est supérieur à une valeur de seuil prédéterminée(Is) pendant une durée de temporisation prédéterminée, lesdits moyens comportant des moyens (3) de comparaison du signal d'entrée (I) et de la valeur de seuil (Is) produisant en sortie un signal (A1) lorsque le signal d'entrée (I) est supérieur à la valeur de seuil, et des moyens de temporisation connectés à la sortie des moyens de comparaison, déclencheur caractérisé en ce que les moyens de temporisation comportent un compteur (4) et un compteur/décompteur (5) comportant chacun une entrée horloge recevant d'un circuit d'horloge (6) des signaux d'horloge (H) de fréquences prédéterminées, une entrée (RAZ) de remise à zéro du compteur (4) étant connectée à la sortie (A1) des moyens de comparaison, la sortie du compteur (4) étant reliée à une entrée (C/D) de comptage/décomptage du compteur/décompteur (5) de manière à en commander le décomptage lorsque le contenu (C1) du compteur (4) atteint une première valeur prédéterminée, le compteur/décompteur (5) fournissant un signal de déclenchement (A3) lorsque son contenu (C2) atteint une seconde valeur prédéterminée.

2. Déclencheur selon la revendication 1, caractérisé en ce qu'il comporte des moyens de redressement (2) connectés à des moyens (1) de mesure du courant et fournissant ledit signal d'entrée (I).

3. Déclencheur selon l'une des revendications 1 et 2, caractérisé en ce que le temps de retard (R), nécessaire pour que le contenu (C1) du compteur (4) atteigne la première valeur prédéterminée en l'absence de remise à zéro du compteur, est supérieure ou égal à un quart de période du courant.

4. Déclencheur selon la revendication 3, caractérisé en ce que ledit temps de retard est supérieur ou égal à une demi-période du courant.

5. Déclencheur selon la revendication 3, caractérisé en ce que ledit temps de retard est supérieur ou égal à 5ms.

6. Déclencheur selon l'une des revendications 3 à 5, caractérisé en ce que ledit temps de retard est inférieur à la différence entre la durée de temporisation prédéterminée et un temps de non déclenchement prédéterminé.

7. Déclencheur selon l'une quelconque des revendications 1 à 6, caractérisé en ce que la durée de temporisation est réglable par modification de la fréquence des signaux d'horloge.

8. Déclencheur selon l'une quelconque des revendications 1 à 7, caractérisé en ce que les signaux d'horloge (H) du compteur (4) et du compteur/ décompteur (5) sont identiques.

EP 0 474 565 A1

FIG.1

FIG.2

FIG.3

EP 0 474 565 A1

T

R⩾10ms

T1 . . . .

Is

I

FIG.4

T

R=5ms

80ms . . . .

Is

I

FIG.5

T

I = Is

T1 . . . .

5ms  10ms

R

FIG.6

EP 0 474 565 A1

**Office européen des brevets**

**RAPPORT DE RECHERCHE EUROPEENNE**

Numero de la demande

EP  91 42 0263

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| D,A | US-A-3792313 (I-T-E IMPERIAL CORPORATION) <br> * abrégé * <br> --- | 1 | H02H3/093 |
| A | US-A-4782422 (SUNSTRAND CORPORATION) <br> * abrégé * <br> ----- | 1 | |

**DOMAINES TECHNIQUES RECHERCHES (Int. Cl.5 )**

H02H

Le présent rapport a été établi pour toutes les revendications

| Lieu de la recherche | Date d'achèvement de la recherche | Examinateur |
|---|---|---|
| LA HAYE | 17 SEPTEMBRE 1991 | LIBBERECHT L.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.................................................................
& : membre de la même famille, document correspondant

EPO FORM 1503 03.82 (P0463)

10